# EUROPÄISCHE PATENTSCHRIFT

(11) **EP 0 756 019 B1**
(45) Veröffentlichungstag und Bekanntmachung des Hinweises auf die Patenterteilung: **10.10.2001**
(21) Anmeldenummer: 96106120.7
(22) Anmeldetag: 18.04.1996
(51) Int. Cl.: C23C 14/02, C23C 14/06, C23C 14/32, C23C 14/34, C23C 14/58

(54) **PVD-Hartstoffbeschichtung**
Hard material coating formed by PVD
Revêtement en matière dure fabriqué par PVD

(30) Priorität: 28.06.1995 DE 19523550
(43) Veröffentlichungstag der Anmeldung: 29.01.1997
(73) Patentinhaber: HAUZER TECHNO COATING EUROPE BV, 5902 RB Venlo (NL)
(72) Erfinder: Münz, Wolf-Dieter Dr., Nether Edge, Sheffield, S71SL (GB); Trinh, Tongh, 6291 BP Vaals (NL)
(74) Vertreter: Finsterwald, Manfred, Dipl.-Ing., Dipl.-Wirtsch.-Ing.

(56) Entgegenhaltungen:
- WO-A-96/30148
- MUENZ W -D ET AL: "DEFECTS IN TIN AND TIAIN COATINGS GROWN BY COMBINED CATHODIC ARC/ UNBALANCED MAGNETRON TECHNOLOGY" VACUUM, Bd. 46, Nr. 4, April 1995, Seiten 323-330, XP000604470
- PATENT ABSTRACTS OF JAPAN vol. 015, no. 436 (C-0882), 7.November 1991 & JP 03 183775 A (SUMITOMO ELECTRIC IND LTD), 9.August 1991,

## Beschreibung

Es ist bekannt, Schneid- und Umformwerkzeuge, hergestellt aus Schnellarbeitsstahl oder Hartmetall, unter Ausnützung der PVD (physical vapour deposition)-Methode mit verschleißreduzierenden Hartstoffen zu beschichten. Das goldfarbene Titannitrid ist ein bekanntes Beispiel dieser Art von Hartstoffen.

In den letzten Jahren wurden neue Schichten entwickelt, die unter bestimmten Bedingungen Werkzeuge weiter verbessern. TiAlN ist einer dieser neuen Schichtwerkstoffe (W.-D. Münz, J. V. Sc. Technol. 1986). TiAlN kann besonders dann erfolgreich angewendet werden, wenn abrasiver Verschleiß oder Verschleiß bei hohen Temperaturen, das heißt wenn Oxidation eine Rolle spielt.

Des weiteren kann TiAlN weiter verbessert werden, wenn TiAlN in feinen Mehrlagenschichten oder in sogenannten "Superlattice"-Schichten, bestehend zum Beispiel aus TiAlN / TiNbN, TiAlN / ZrN oder TiAlN / W₂N auf die zu beschichtenden Werkzeuge aufgebracht wird. Dabei wird TiAlN vorzugsweise mit Hilfe der Kathodenzerstäubung, insbesondere mit dem unbalanzierten Magnetron hergestellt. Eine besonders aussichtsreiche Beschichtungsmethode stellt dabei die sogenannte ABS-Technik dar, bei der die bekannte PVD-Methode der kathaodischen Bogenentladung mit der der unbalanzierten Magnetron-Kathodenzerstäubung-Technik kombiniert wird (EP 0 439 561).

Es hat sich jedoch herausgestellt, daß bei der Vorbehandlung der zu beschichtenden Teile mit hochionisiertem TiAl-Dampf, dem sogenannten Metall-Ionen-Ätzen mit der kathodischen Bogenentladung, sogenannte Droplets auf den Teilen abscheiden, die dann bei der weiteren Beschichtung mit TiAlN mit dem unbalanzierten Magnetron zu Wachstumsdefekten führen, die insbesondere die Oberflächenrauhigkeit der TiAlN-Schichten von typischerweise Rₐ = 0,03 *µ*m / R_{z} = 0,4 *µ*m auf Rₐ > 0,2 *µ*m / R_{z} > 1 *µ*m erhöhen. Diese erhöhten Schichtrauhigkeiten verhalten sich bei erhöhten Schichtansprüchen nachteilig.

Bei ungekühltem Schneidbetrieb zum Beispiel wird die Schneidtemperatur aufgrund von Reibungseffekten besonders stark erhöht und führt zu einer Reduzierung der durch TiAlN an sich erreichten hohen Standzeitverlängerung. Besonders nachteilig kann sich die Ausbildung dieser Wachstumsdefekte auch bei Umformprozessen, wie dem "fine-blanking" (Fein-Stanzen) auswirken. In diesem Fall werden die Wachstumsdefekte, die relativ locker in das Schichtgefüge eingebaut sind (W.-D. Münz et al., Vaccum, 1995) während des Stanzprozesses aus dem Schichtverband herausgeschlagen. Die dabei entstehenden Löcher füllen sich mit dem zu bearbeitenden Material, zum Beispiel Stahl, und geben dann Anlaß zur Bildung von Aufbauschweißungen. Diese bilden wiederum den Kern zu einer sich sehr schnell ausbreitenden Schichtzerstörung.

Der Effekt der an sich nachteiligen Wachstumsdefekte wird in der vorliegenden Erfindung vorteilhat zur weiteren Verbesserung der Schichteigenschaften ausgenutzt.

Während TiN, TiCN oder ZrN Hartstoffschichten, hergestellt nach dem ABS-Verfahren oder auch nach dem kathodischen Bogenentladungsaufdampfverfahren, relativ geringe Wachstumsdefekt-Konzentrationen aufweisen (W.-D. Münz et al., Vacuum, 1995; L. A. Donohue et al., Surf Coat Technol., 1995), treten wegen des niedrigen Schmelzpunktes von Al bzw. TiAlN beim Bogenentladungsvorbehandlungsprozeß wesentlich häufigere Wachstumsdefektbildungen auf. Es hat sich jedoch überraschenderweise gezeigt, daß sich diese Defekte relativ leicht durch eine mechanische Polier- oder Abreibbehandlung, zum Beispiel mit Scotch-Bright-Polierstoff, aus der Schicht herausreiben lassen.

Im besonderen Maße eignen sich jedoch Sandstrahlverfahren mit Al₂O₃-Granulat, um eine "Glättung" der Oberfläche durchzuführen. Dabei soll das Strahlverfahren nicht zu "scharf" gewählt werden, um eine Zerstörung der Beschichtung selbst soweit als möglich zu vermeiden. Es hat sich zum Beispiel herausgestellt, daß ein Biasdruck von 1 Bar bei einem Strahlwinkel von 45° und einer Behandlungsdauer von 30 Sekunden völlig ausreichen, um die oben genannten Rauhigkeitswerte einer TiAlN-Beschichtung auf fast identische Werte der durch Wachstumsdefekte ungestörten Schicht zurückzuführen. Tatsächlich wurden nach der Sandstrahlbehandlung Rauhigkeitswerte Rₐ = 0,04 *µ*m / R_{z} = 0,7 ± 0,3 *µ*m gemessen. Im Rasterelektronenmikroskop konnte darüber hinaus nachgewiesen werden, daß sich nun Löcher gebildet haben, die sich mit konventionellen Oberflächenrauhigkeitsmeßgeräten allerdings nicht mehr messen lassen.

Die Erfindung besteht nun im wesentlichen darin, eine derart vorbehandelte, mit Löchern oder Hohlräumen versehene TiAlN-Schicht zu benützen, um sie nach der mechanischen Vorbehandlung mit der an sich bekannten Reibungsreduzierenden MoS₂ (Rechberger et al., Surf Coat Technol., 1994) zu beschichten und zu füllen.

Die Schichtdicke von MoS₂ liegt vorteilhaft bei 0,5 *µ*m bis 2 *µ*m. Dabei werden die freiliegenden Löcher mit MoS₂ gefüllt. Da die Löcher bis zum Grund der Hartstoffschicht TiAlN reichen, wirken diese Löcher als Schmierstoffvorratsquelle praktisch bis ans Funktionsende der Beschichtung.

Im praktischen Einsatz hat sich gezeigt, daß sich die Lebensdauer von unbeschichteten Stanzwerkzeugen von etwa 10.000 bis 15.000 Stanzhüben mit einer TiN-Beschichtung auf 30.000 Stanzhübe, mit einer nicht erfindungsgemäß behandelten TiAlN-Beschichtung auf circa 60.000 Stanzhübe und mit einer erfindungsgemäß behandelten Schicht auf 100.000 bis 150.000 Stanzhübe verlängern läßt.

Weitere Einzelheiten sind in den Ansprüchen zu sehen.

## Patentansprüche

1. Verfahren zur Herstellung einer PVD-Hartstoffbeschichtung, bei dem nach dem ABS-Verfahren oder nach einem kombinierten kathodischen Bogenentladungs-Kathodenzerstäubungsverfahren oder nach dem kathodischen Bogenentladungsaufdampfverfahren eine Grundbeschichtung mit einer etwa 1 *µ*m bis 5 *µ*m dicken Schicht aus TiAlN oder aus TiAlYN oder aus TiAlCrN oder eine auf TiAlN basierende Mehrlagenschicht aufgebracht und diese Schicht mechanisch geglättet wird, worauf die geglättete Schicht einer zweiten PVD-Beschichtung mit MoS₂ unterzogen wird.

2. Verfahren nach Anspruch 1,
**dadurch gekennzeichnet,**
**daß** die mechanische Nachbehandlung insbesondere mit einem Sandstrahlverfahren ausgeführt wird.

3. Verfahren nach Anspruch 1 oder 2,
**dadurch gekennzeichnet,**
**daß** eine MoS₂-Schicht mit einer Dicke von etwa 0,5 *µ*m bis 2 *µ*m aufgebracht wird.

4. Verfahren nach einem der Ansprüche 1 bis 3,
**dadurch gekennzeichnet,**
**daß** ein Metallionenätzvorgang mit der kathodischen Bogenentladung ausschließlich mit dem TiAl-Target durchgeführt wird.

5. Verfahren nach einem der vorhergehenden Ansprüche,
**dadurch gekennzeichnet,**
**daß** das TiAl-Target pulvermetallurgisch hergestellt wird.

6. Verfahren nach einem der vorhergehenden Ansprüche,
**dadurch gekennzeichnet,**
**daß** das TiAl-Target schmelzmetallurgisch hergestellt wird.

7. PVD-Hartstoffbeschichtung, hergestellt nach dem ABS-Verfahren oder nach oder einem kombinierten kathodischen Bogenentladungs-Kathodenzerstäubungsverfahren oder nach dem kathodischen Bogenentladungsaufdampfverfahren, bestehend aus einer Grundbeschichtung mit einer etwa 1 *µ*m bis 5 *µ*m dicken Schicht aus TiAlN oder TiAlYN oder TiAlCrN oder einer auf TiAlN basierenden Mehrlagenschicht sowie einer auf die mechanisch geglättete Grundbeschichtung aufgebrachten MoS₂-Schicht, die vorzugsweise eine Dicke von 0,5 *µ*m bis 2 *µ*m aufweist.

8. PVD-Hartstoffbeschichtung,
**dadurch gekennzeichnet,**
**daß** der Aluminiumanteil des TiAl-Targets vorzugsweise zwischen 30 at-% und 70 at-% liegt.

9. PVD-Hartstoffbeschichtung nach einem der vorhergehenden Ansprüche,
**dadurch gekennzeichnet,**
**daß** die MoS₂-Schicht eine Dicke von etwa 0,5 *µ*m bis 2 *µ*m aufweist.

10. PVD-Hartstoffbeschichtung nach einem der vorhergehenden Ansprüche,
**dadurch gekennzeichnet,**
**daß** die aufgebrachte MoS₂-Schicht in Verbindung mit einer Haftschicht aus TiAl oder TiAlN in einer Dicke von etwa 0,05 *µ*m bis 0,2 *µ*m aufgebracht ist.

## Claims

1. A method for the manufacture of a PVD hard material coating in which a base coating having a layer with a thickness of approximately 1 µm to 5 µm of TiAlN or of TiAlYN or of TiAlCrN, or a multi-layer coating based on TiAlN, is applied in accordance with the ABS method or in accordance with a combined cathodic arc discharge atomisation / cathode sputtering method or in accordance with the cathodic arc discharge deposition method and in which this layer is mechanically smoothed, whereupon the smoothed layer is subjected to a second PVD coating with MoS₂.

2. A method in accordance with claim 1, **characterised in that** the mechanical post-treatment is in particular carried out with a sand blasting method.

3. A method in accordance with claim 1 or claim 2, **characterised in that** an MoS₂ layer is applied with a thickness of approximately 0.5 µm to 2 µm.

4. A method in accordance with any of claims 1 to 3, **characterised in that** a metal ion etching process by the cathodic arc discharge method is carried out exclusively with the TiAl target.

5. A method in accordance with any one of the preceding claims, **characterised in that** the TiAl target is manufactured by powder metallurgy.

6. A method in accordance with any one of the preceding claims, **characterised in that** the TiAl target is manufactured by a metallurgical melting process.

7. A PVD hard material coating, manufactured in accordance with the ABS method or in accordance with a combined cathodic are discharge atomisation /cathode sputtering method or in accordance with the cathodic arc discharge deposition method, consisting of a base coating having a layer with a thickness of approximately 1 µm to 5 µm of TiAlN or of TiAlYN or of TiAlCrN or a multi-layer coating based on TiAlN and also consisting of an MoS₂ layer which is applied to the mechanically smoothed base coating and which preferably has a thickness of 0.5 µm to 2 µm.

8. A PVD hard material coating, **characterised in that** the proportion of aluminium in the TiAl target is preferably between 30 at% and 70 at%.

9. A PVD hard material coating in accordance with any one of the preceding claims, **characterised in that** the MoS₂ layer has a thickness of approximately 0.5 µm to 2 µm.

10. A PVD hard material coating in accordance with any one of the preceding claims, **characterised in that** the applied MoS₂ layer is applied in a thickness of approximately 0.05 µm to 0.2 µm in combination with an adhesive layer of TiAl or TiAlN.

## Revendications

1. Procédé de fabrication d'un revêtement de substance dure, appliqué par dépôt physique en phase vapeur dit PVD, dans lequel, selon le procédé ABS ou selon un procédé combiné de décharge cathodique en arc-pulvérisation cathodique ou selon le procédé de métallisation sous vide avec décharge cathodique en arc, on applique un revêtement de base avec une couche, d'environ 1 *µ*m à 5 *µ*m d'épaisseur, de TiAlN ou de TiAlYN ou de TiAlCrN ou un revêtement multi-couches à base de TiAlN et on polit cette couche mécaniquement, après quoi on soumet la couche polie à un second revêtement PVD avec du MoS₂.

2. Procédé selon la revendication 1, **caractérisé en ce qu'**on effectue le post-traitement mécanique en particulier avec un procédé de décapage au sable.

3. Procédé selon la revendication 1 ou 2, **caractérisé en ce qu'**on applique une couche de MoS₂ ayant une épaisseur d'environ 0,5 *µ*m à 2 *µ*m.

4. Procédé selon l'une des revendications 1 à 3, **caractérisé en ce qu'**on effectue une opération d'attaque par ions métalliques avec la décharge cathodique en arc exclusivement avec la cible de TiAl.

5. Procédé selon l'une des revendications précédentes, **caractérisé en ce qu'**on prépare la cible de TiAl par mise en oeuvre de la métallurgie des poudres.

6. Procédé selon l'une des revendications précédentes, **caractérisé en ce qu'**on prépare la cible de TiAl par utilisation de la métallurgie des masses fondues.

7. Revêtement PVD de substance dure, fabriqué selon le procédé ABS ou selon un procédé combiné de décharge cathodique avec arc-pulvérisation cathodique ou selon le procédé de métallisation sous vide avec décharge cathodique en arc, constitué d'un revêtement de base avec une couche, d'environ 1 *µ*m à 5 *µ*m d'épaisseur, de TiAlN ou de TiAlYN ou de TiAlCrN ou d'un revêtement multi-couches à base de TiAlN, ainsi que d'une couche de MoS₂ appliquée sur le revêtement de base poli mécaniquement et qui, de préférence, présente une épaisseur de 0,5 *µ*m à 2 *µ*m.

8. Revêtement PVD de substance dure, **caractérisé en ce que** la proportion d'aluminium de la cible de TiAl est comprise de préférence entre 30 % at et 70 % at.

9. Revêtement PVD de substance dure selon l'une des revendications précédentes, **caractérisé en ce que** la couche de MoS₂ présente une épaisseur d'environ 0,5 *µ*m à 2 *µ*m.

10. Revêtement PVD de substance dure selon l'une des revendications précédentes, **caractérisé en ce que** la couche appliquée de MoS₂ est appliquée en liaison avec une couche d'adhérence en TiAl ou TiAlN en une épaisseur d'environ 0,05 *µ*m à 0,2 *µ*m.
